(19) Europäisches Patentamt
European Patent Office
Office européen des brevets

(11) **EP 4 770 401 A1**

(12) **EUROPEAN PATENT APPLICATION**
published in accordance with Art. 153(4) EPC

(43) Date of publication:
**01.07.2026 Bulletin 2026/27**

(21) Application number: 24856285.2

(22) Date of filing: **06.08.2024**

(51) International Patent Classification (IPC):
*H10P 10/00* (2026.01)   *C30B 25/20* (2006.01)
*C30B 29/06* (2006.01)   *C30B 33/02* (2006.01)

(52) Cooperative Patent Classification (CPC):
**C30B 25/20; H10P 14/20; H10P 14/29;**
**H10P 95/00; H10P 95/90;** C30B 29/06; C30B 33/02

(86) International application number:
**PCT/JP2024/028032**

(87) International publication number:
**WO 2025/041594 (27.02.2025 Gazette 2025/09)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **23.08.2023 JP 2023135700**

(71) Applicant: **Shin-Etsu Handotai Co., Ltd.**
**Tokyo 100-0004 (JP)**

(72) Inventors:
• **IKIGAKI, Ken**
  **Annaka-shi, Gunma 379-0196 (JP)**
• **SUZUKI, Atsushi**
  **Nishishirakawa-gun, Fukushima 961-8061 (JP)**

(74) Representative: **Schicker, Silvia**
**Wuesthoff & Wuesthoff**
**Patentanwälte und Rechtsanwalt PartG mbB**
**Schweigerstraße 2**
**81541 München (DE)**

(54) **SOI WAFER AND METHOD FOR MANUFACTURING SAME**

(57)     The present invention is an SOI wafer including, in this order, a silicon epitaxial film having a carbon concentration of $2 \times 10^{19}$ atoms/cm$^3$ or more and less than $3 \times 10^{20}$ atoms/cm$^3$ and containing carbon defects, a dielectric layer, and a silicon single crystal film on a silicon single crystal substrate having a resistivity of 10 Ω·cm or more and 5000 Ω·cm or less, in which a thickness of the silicon epitaxial film satisfies $6.6 \times 10^{20} \times \exp\{-1.6 \times$ [the thickness of the epitaxial film (μm)]} > [the carbon concentration of the epitaxial film (atoms/cm$^3$) ]. This pro- vides the SOI wafer employing an epitaxial wafer having the silicon epitaxial film containing a high concentration of carbon formed on a standard resistivity substrate, the SOI wafer having superior harmonic reduction capability compared with a conventional SOI wafer that employs a polysilicon layer as a trap-rich layer, and being excellent in terms of ease of processing for use as a substrate for a high-frequency integrated circuit, as well as a method for manufacturing the same.

[FIG. 1]

1

EP 4 770 401 A1

**Description**

TECHNICAL FIELD

The present invention relates to an SOI wafer and a method for manufacturing the same.

BACKGROUND ART

In recent years, demand for high-capacity communication has been extremely high, and development of equipment for use in fifth and sixth-generation mobile communication systems (commonly known as 5G and 6G) is accelerating. These items of telecommunication equipment are incorporated with integrated circuits, and active devices (such as transistors) and passive devices (such as inductors) that constitute the integrated circuits are required to have high operational stability under 5G and 6G environments. In particular, high-frequency bands (from millimetric-wave to sub-terahertz band) are expected to be used in these high-capacity telecommunication systems; therefore, device designs and material developments that combine excellent high-frequency characteristics with power-saving performance are socially required.

When turning to materials required for semiconductor integrated circuits, silicon wafers produced by a CZ (Czochralski) method are sometimes employed as substrates for high-frequency integrated circuits. The silicon wafers used in these cases are required to have high substrate resistivity in order to achieve low resistivity losses and excellent high-frequency characteristics.

Furthermore, in applications where more excellent high-frequency characteristics are required, wafers in which trap-rich (Trap-rich) layers are formed, as disclosed in Patent Document 1 and Patent Document 2, are commonly used. This is because it is known that when a high-frequency signal is input into a device formed on a high-resistivity substrate, an inversion layer is formed in the substrate, and this leads to a phenomenon in which resistivity thereof is changed; consequently, the trap-rich layer captures a carrier generated in the inversion layer at a deep level, and this enables high substrate resistivity to be maintained. In particular, for the passive device, a wafer is used, in which a polysilicon layer is formed as the trap-rich layer on the high-resistivity substrate. In contrast, an SOI wafer having a trap-rich layer is widely used for the active device. In a structure of such an SOI wafer, the polysilicon layer as the trap-rich layer, an oxide film as a dielectric layer, and a single-crystal silicon layer are stacked on the high-resistivity substrate in this order.

However, production of the high-resistivity substrate, which is widely used as the substrate for the high-frequency integrated circuit, poses a great technical difficulty in controlling the resistivity, resulting in low yield. Additionally, polysilicon used for the trap-rich layer presents high processing difficulty, which leads to productivity degradation. Furthermore, an SOI structure, in which polysilicon is used for the trap-rich layer, has complex production processes and a major issue related to cost. Accordingly, development of techniques has been required to exhibit excellent high-frequency characteristics and, in particular, reduce harmonics by producing an SOI wafer, in which a wafer with a silicon epitaxial film formed on a silicon single crystal substrate (hereinafter, also simply referred to as "silicon substrate") is employed, without using the high-resistivity substrate.

Moreover, Patent Document 3 and Patent Document 4 disclose wafers having carbon-doped epitaxial films formed on a silicon substrate. However, the wafers disclosed in Patent Document 3 and Patent Document 4 are essentially epitaxial wafers composed of a silicon substrate, a carbon-doped epitaxial film, and a silicon epitaxial film, primarily intended for use in imaging devices, and the use of an epitaxial layer as a trap-rich layer to form an SOI wafer has not been studied. Moreover, Patent Document 3 and Patent Document 4 do not disclose performing heat treatment after epitaxial film formation; consequently, no trap-rich layer is formed within the epitaxial film.

Furthermore, Patent Document 5 discloses an epitaxial wafer subjected to heat treatment on a wafer where a carbon-doped epitaxial film has been formed on a silicon substrate. However, no reference is made to applications for wafers for high-frequency devices, or SOI wafers having trap-rich layers formed thereon.

In Patent Document 5, a silicon epitaxial film having a high concentration of carbon is developed with the intention of utilizing it as a gettering layer, and the purpose of the heat treatment is to drive a gettering. Consequently, heat treatment conditions are disclosed as approximately 30 minutes within a range of 450 to 750°C. Although the heat treatment at 800 to 1000°C is also disclosed to drive the gettering in a shorter time, it is inferred that the heat treatment time is 30 minutes or less. However, under such conditions, it is difficult to obtain stable high-frequency characteristics.

From the foregoing, the wafers disclosed in Patent Document 3, Patent Document 4, and Patent Document 5 have difficulties in being employed as wafers for a high-frequency device.

CITATION LIST

PATENT LITERATURE

Patent Document 1: JP 2015-503853 A
Patent Document 2: JP 2019-129195 A
Patent Document 3: JP 2009-164590 A
Patent Document 4: JP 2009-200231 A
Patent Document 5: JP 2006-216934 A

SUMMARY OF INVENTION

TECHNICAL PROBLEM

As described above, as a substrate for a high-frequency integrated circuit, an SOI wafer has been desired, which is capable of reducing harmonics without using a high resistivity substrate, and also replacing a polysilicon layer as a trap-rich layer. In earnest pursuit of developing a material capable of meeting such requirements, the present inventors found that an SOI wafer employing an epitaxial wafer in which a silicon epitaxial film containing a high concentration of carbon is formed on a standard resistivity substrate is promising. This can provide the substrate for the high-frequency integrated circuit that can be produced with fewer steps and easier processing.
However, even these substrates do not reach the levels of harmonics reduction capability exhibited by the conventional SOI wafers using a polysilicon layer as a trap-rich layer. Thus, the development of an SOI wafer exhibiting superior high-frequency characteristics has been an urgent priority.
The present invention has been made in view of the above-described problem. An object of the present invention is to provide an SOI wafer employing an epitaxial wafer having the silicon epitaxial film containing a high concentration of carbon formed on a standard resistivity substrate, the SOI wafer having superior harmonic reduction capability compared with a conventional SOI wafer that employs a polysilicon layer as a trap-rich layer, and being excellent in terms of ease of processing for use as a substrate for a high-frequency integrated circuit, as well as a method for manufacturing the same.

SOLUTION TO PROBLEM

To achieve the object, the present invention provides an SOI wafer comprising, in this order, a silicon epitaxial film having a carbon concentration of $2 \times 10^{19}$ atoms/cm$^3$ or more and less than $3 \times 10^{20}$ atoms/cm$^3$ and containing carbon defects, a dielectric layer, and a silicon single crystal film on a silicon single crystal substrate having a resistivity of 10 $\Omega \cdot$cm or more and 5000 $\Omega \cdot$cm or less, wherein a thickness of the silicon epitaxial film satisfies $6.6 \times 10^{20} \times \exp\{-1.6 \times$ [the thickness of the epitaxial film ($\mu$m)]$\} >$ [the carbon concentration of the epitaxial film (atoms/cm$^3$)].

In this SOI wafer, the silicon epitaxial film containing minute carbon defects functions as a trap-rich layer; accordingly, this SOI wafer exhibits superior high-frequency characteristics compared with a conventional SOI wafer employing a polysilicon layer as a trap-rich layer.
In this case, the SOI wafer can be a wafer for a high-frequency device.
The SOI wafer according to the present invention exhibits superior high-frequency characteristics compared with a conventional SOI wafer employing a polysilicon layer as a trap-rich layer by functioning the silicon epitaxial film containing the minute carbon defects as the trap-rich layer, and is therefore suitable for the wafer for a high-frequency device.
In this case, the carbon defects can have a size of 10 nm or less, and a density of $1 \times 10^{10}$ cm$^{-2}$ or more in the silicon epitaxial film.
The SOI wafer containing such carbon defects more stably exhibits superior high-frequency characteristics compared with a conventional SOI wafer employing a polysilicon layer as a trap-rich layer.
The present invention also provides a method for manufacturing an SOI wafer, the method comprising the steps of:

providing a first substrate that is a silicon single crystal substrate having a resistivity of 10 $\Omega \cdot$cm or more and 5000 $\Omega \cdot$cm or less;
vapor-phase growing a silicon epitaxial film having a carbon concentration of $2 \times 10^{19}$ atoms/cm$^3$ or more and less

than $3\times10^{20}$ atoms/cm$^3$ on the first substrate, under reduced pressure;

forming carbon defects in the silicon epitaxial film by subjecting the first substrate on which the silicon epitaxial film has been formed to heat treatment at a heat treatment temperature of 900°C or more and 1100°C or less for a heat treatment time of 3 hours or more and 36 hours or less;

providing a second substrate that is a silicon single crystal substrate;

forming a dielectric layer on a surface of the second substrate; and

bonding the epitaxial film formed on the first substrate to the dielectric layer of the second substrate, wherein the silicon epitaxial film is formed in the step of vapor-phase growing a silicon epitaxial film, in which the silicon epitaxial film has a thickness that satisfies $6.6 \times 10^{20} \times \exp\{-1.6 \times$ [the thickness of the epitaxial film ($\mu$m)]$\} >$ [the carbon concentration of the epitaxial film (atoms/cm$^3$)].

According to this method for manufacturing an SOI wafer, vapor-phase growth on the first substrate and subsequent heat treatment of the first substrate enable the formation of minute carbon defects at high density in the silicon epitaxial film of the first substrate. In addition, by manufacturing the SOI wafer using a bonding method employing the first substrate as a base wafer, by virtue of the silicon epitaxial film functioning as a trap-rich layer, it is possible to easily manufacture the SOI wafer having superior high-frequency characteristics compared with a conventional SOI wafer employing a polysilicon layer as a trap-rich layer.

The present invention also provides a method for manufacturing an SOI wafer, the method comprising the steps of:

providing a first substrate that is a silicon single crystal substrate having a resistivity of 10 $\Omega$·cm or more and 5000 $\Omega$·cm or less;

vapor-phase growing a silicon epitaxial film having a carbon concentration of $2\times10^{19}$ atoms/cm$^3$ or more and less than $3\times10^{20}$ atoms/cm$^3$ on the first substrate, under reduced pressure;

forming carbon defects in the silicon epitaxial film and forming an oxide film on the silicon epitaxial film, by subjecting the first substrate on which the silicon epitaxial film has been formed to heat treatment at a heat treatment temperature of 900°C or more and 1100°C or less for a heat treatment time of 3 hours or more and 36 hours or less in an oxidizing atmosphere;

providing a second substrate that is a silicon single crystal substrate; and

bonding the oxide film, which is formed on the epitaxial film formed on the first substrate, to the second substrate, wherein

the silicon epitaxial film is formed in the step of vapor-phase growing a silicon epitaxial film, in which the silicon epitaxial film has a thickness that satisfies $6.6 \times 10^{20} \times \exp\{-1.6 \times$ [the thickness of the epitaxial film ($\mu$m)]$\} >$ [the carbon concentration of the epitaxial film (atoms/cm$^3$)].

According to the method for manufacturing an SOI wafer, minute carbon defects can also be formed in the silicon epitaxial film of the first substrate at high density. By using this substrate as a base wafer and manufacturing the SOI wafer using a bonding method, by virtue of the silicon epitaxial film functioning as the trap-rich layer, it is possible to easily manufacture the SOI wafer having superior high-frequency characteristics compared with a conventional SOI wafer employing a polysilicon layer as a trap-rich layer.

In this case, the second substrate can be a substrate obtained by cutting one silicon single crystal substrate into a plurality of substrates to thin the substrate prior to being bonded to the first substrate.

As described above, a plurality of silicon substrates acting as the second substrate required for the inventive SOI wafer can be cut out to manufacture from one silicon single crystal substrate. This provides significant advantages in view of the manufacturing cost.

In this case, the SOI wafer manufactured by the method for manufacturing an SOI wafer described above can be employed as a wafer for a high-frequency device.

The SOI wafer manufactured by the method for manufacturing an SOI wafer has superior high-frequency characteristics compared with a conventional SOI wafer employing a polysilicon layer as a trap-rich layer. This is because the silicon epitaxial film, in which minute carbon defects are formed at high density, functions as the trap-rich layer. Consequently, this wafer is particularly suitable for the wafer for a high-frequency device.

In this case, the carbon defects can have a size of 10 nm or less, and a density of $1\times10^{10}$ cm$^{-2}$ or more in the epitaxial film.

By making the SOI wafer containing such carbon defects, the SOI wafer can be more reliably obtained, which achieves superior high-frequency characteristics compared with a conventional SOI wafer employing a polysilicon layer as a trap-rich layer.

ADVANTAGEOUS EFFECTS OF INVENTION

As described above, according to the inventive SOI wafer, a high-resistivity substrate is not required, and the silicon epitaxial film containing minute carbon defects functions as the trap-rich layer, and thus, the SOI wafer has superior harmonics reduction capability compared with a conventional SOI wafer employing a polysilicon layer as a trap-rich layer and is suitable for a wafer for a high-frequency device. Moreover, according to the inventive method for manufacturing an SOI wafer, the SOI wafer having superior harmonics reduction capability can be easily manufactured.

BRIEF DESCRIPTION OF DRAWINGS

[FIG. 1] is a schematic view illustrating an SOI wafer according to the present invention.
[FIG. 2] is a flow diagram showing an example of a method for manufacturing an SOI wafer according to the first embodiment of the present invention.
[FIG. 3] is a flow diagram showing an example of a method for manufacturing an SOI wafer according to the second embodiment of the present invention.
[FIG. 4] is a flow diagram showing an example of a method for manufacturing an SOI wafer according to the third embodiment of the present invention.
[FIG. 5] is a graph showing the conditions of carbon concentrations of silicon epitaxial films and film thicknesses of silicon epitaxial films, where Void defect regions are formed in the vicinity of an interface between a silicon epitaxial film and a silicon substrate, in the inventive SOI wafer.
[FIG. 6] is a plot showing variations in the second harmonics and the third harmonics characteristics of an epitaxial wafer in Experimental Example 2 when heat treatment is performed on the epitaxial wafer with varying heat treatment time.
[FIG. 7] is a graph showing a relation between the second harmonics characteristics and carbon concentrations, and a relation between the third harmonics characteristics and carbon concentrations, of epitaxial wafers in Example 1 and Comparative Examples 1 and 2.

DESCRIPTION OF EMBODIMENTS

Hereinafter, the present invention will be described in detail. However, the present invention is not limited thereto.
As described above, due to demands for miniaturization, power saving, and cost reduction of communication devices, an inexpensive SOI wafer having further improved high-frequency characteristics, in particular, capable of reducing harmonics, has been desired.
The inventors, as a result of earnest studies on the above problem, have found that, by employing an SOI wafer including, in this order, a silicon epitaxial film having a carbon concentration of $2 \times 10^{19}$ atoms/cm$^3$ or more and less than $3 \times 10^{20}$ atoms/cm$^3$ and containing carbon defects, a dielectric layer, and a silicon single crystal film on a silicon single crystal substrate having a resistivity of 10 $\Omega \cdot$cm or more and 5000 $\Omega \cdot$cm or less, in which a thickness of the silicon epitaxial film satisfies

$6.6 \times 10^{20} \times \exp\{-1.6 \times$ [the thickness of the epitaxial film ($\mu$m)]$\} >$ [the carbon concentration of the epitaxial film (atoms/cm$^3$)],

the SOI wafer exhibits superior harmonic reduction capability compared with a conventional SOI wafer employing a polysilicon layer as a trap-rich layer, by virtue of the action of the silicon epitaxial film containing minute carbon defects. This finding led to the completion of the present invention.
The inventors have also found that, by employing a method for manufacturing an SOI wafer, the method includes the steps of providing a first substrate that is a silicon single crystal substrate having a resistivity of 10 $\Omega \cdot$cm or more and 5000 $\Omega \cdot$cm or less, vapor-phase growing a silicon epitaxial film having a carbon concentration of $2 \times 10^{19}$ atoms/cm$^3$ or more and less than $3 \times 10^{20}$ atoms/cm$^3$ on the first substrate, under reduced pressure, forming carbon defects in the silicon epitaxial film by subjecting the first substrate on which the silicon epitaxial film has been formed to heat treatment at a heat treatment temperature of 900°C or more and 1100°C or less for a heat treatment time of 3 hours or more and 36 hours or less, providing a second substrate that is a silicon single crystal substrate, forming a dielectric layer on a surface of the second substrate, and bonding the epitaxial film formed on the first substrate to the dielectric layer of the second substrate, in which the silicon epitaxial film is formed in the step of vapor-phase growing a silicon epitaxial film, in which the silicon epitaxial film has a thickness that satisfies

6.6 $\times$ 10$^{20}$ $\times$ exp{-1.6 $\times$ [the thickness of the epitaxial film ($\mu$m)]} > [the carbon concentration of the epitaxial film (atoms/cm$^3$)],

the SOI wafer, having excellent harmonic reduction capability, can be easily manufactured. This finding led to the completion of the present invention.

The inventors have also found that, by employing a method for manufacturing an SOI wafer, the method includes the steps of providing a first substrate that is a silicon single crystal substrate having a resistivity of 10 $\Omega$·cm or more and 5000 $\Omega$·cm or less, vapor-phase growing a silicon epitaxial film having a carbon concentration of 2$\times$10$^{19}$ atoms/cm$^3$ or more and less than 3$\times$10$^{20}$ atoms/cm$^3$ on the first substrate, under reduced pressure, forming carbon defects in the silicon epitaxial film and forming an oxide film on the silicon epitaxial film, by subjecting the first substrate on which the silicon epitaxial film has been formed to heat treatment at a heat treatment temperature of 900°C or more and 1100°C or less for a heat treatment time of 3 hours or more and 36 hours or less in an oxidizing atmosphere, providing a second substrate that is a silicon single crystal substrate, and bonding the oxide film, which is formed on the epitaxial film formed on the first substrate, to the second substrate, in which the silicon epitaxial film is formed in the step of vapor-phase growing a silicon epitaxial film, in which the silicon epitaxial film has a thickness that satisfies

6.6 $\times$ 10$^{20}$ $\times$ exp{-1.6 $\times$ [the thickness of the epitaxial film ($\mu$m)]} > [the carbon concentration of the epitaxial film (atoms/cm$^3$)],

the SOI wafer, having excellent harmonic reduction capability, can be easily manufactured. This finding led to the completion of the present invention.

[Inventive SOI wafer]

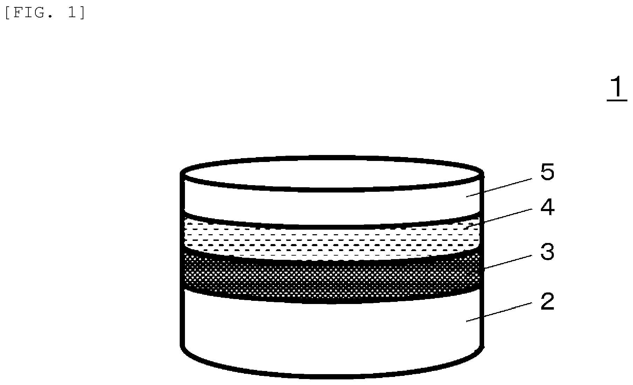

Hereinafter, the inventive SOI wafer will be described with reference to FIG. 1. As shown in FIG. 1, the inventive SOI wafer 1 is provided with a silicon epitaxial film 3 containing carbon defects, a dielectric layer 4, and a silicon single crystal substrate 5 in this order on a silicon single crystal substrate 2.

The silicon single crystal substrate 2 has a resistivity of 10 $\Omega$·cm or more and 5000 $\Omega$·cm or less. The silicon single crystal substrate 2, having a resistivity in this range, is a substrate that can be employed for a high-frequency device. In particular, it is more preferable that the resistivity described above is approximately 1000 to 5000 $\Omega$·cm, in which high-frequency characteristics are excellent, and the resistivity is controllable during the production of a single crystal.

The silicon epitaxial film 3 contains carbon at a concentration of 2$\times$10$^{19}$ atoms/cm$^3$ or more and less than 3$\times$10$^{20}$ atoms/cm$^3$, which significantly exceeds a typical solid solubility limit of carbon of 3$\times$10$^{17}$ atoms/cm$^3$ (maximum solid solubility limit of carbon at a melting point of silicon) and contains the carbon defects. Moreover, the Void defects are not contained therein.

It is preferable that minute carbon defects contained in the silicon epitaxial film 3 have a size of approximately 10 nm or less, and a density of approximately 1$\times$10$^{10}$ cm$^{-2}$ or more in the silicon epitaxial film 3 (when the carbon concentration of the silicon epitaxial film 3 is lower than that in the present invention, the carbon defects having a size of approximately 25 nm or more are included at low density). The lower limit of the size and the upper limit of the density are not particularly limited but can be 3 nm or more and 1$\times$10$^{12}$ cm$^{-2}$ or less, respectively. Note that the size of the carbon defects is defined as a measured value of the longest portion of the defects, which is detected in a cross-sectional TEM. This also applies to the method for manufacturing an SOI wafer described later.

The thickness and the carbon concentration of the silicon epitaxial film 3 satisfy a relation of 6.6 $\times$ 10$^{20}$ $\times$ exp{-1.6 $\times$ [the thickness of the epitaxial film ($\mu$m)]} > [the carbon concentration (atoms/cm$^3$) of the epitaxial film] such that the silicon epitaxial film 3 does not contain the Void defects.

The minute carbon defects contained in the silicon epitaxial film 3 at high density newly form a deep level in the film, thereby producing a trap-rich SOI wafer. The SOI wafer thus obtained exhibits an advantage of the minute carbon defects while eliminating a disadvantage of the Void defects and providing excellent harmonic characteristics. This is considered to be attributed to the silicon epitaxial film, in which the minute carbon defects are formed at high density, functioning as the trap-rich layer, inhibiting an inversion layer formation. Consequently, this substrate becomes suitable for the wafer for a high-frequency device or an active device.

The lower limit of the carbon concentration of the silicon epitaxial film 3 is defined as 2.0 $\times$ 10$^{19}$ atoms/cm$^3$ or more, the upper limit of that is defined as less than 3$\times$10$^{20}$ atoms/cm$^3$. Such carbon concentration significantly exceeds a typical solid solubility limit of carbon, enabling the formation of a high density of minute carbon defects during heat treatment, thereby achieving sufficiently high-frequency characteristics. In contrast, when the carbon concentration is lower than the lower limit, low supersaturation of carbon results in the formation of coarse carbon defects, and reduced defect density, preventing the achievement of sufficiently high-frequency characteristics. On the other hand, when the carbon concentration is 2.0 $\times$ 10$^{19}$ atoms/cm$^3$ or more, the Void defects are formed by an excess of the film thickness over a predetermined value, leading to the coexistence of the Void defects and the minute carbon defects in the film. This causes improvement in the high-frequency characteristics by heat treatment, but the range of improvement becomes smaller. This is considered that the volume of the Void defects is significantly larger compared with that of the carbon defects, thereby making the effect of the Void defects dominant. Consequently, in order for the SOI wafer to exhibit significantly excellent high-frequency characteristics, it is important that the thickness of the silicon epitaxial film 3 be sufficiently thin to prevent the formation of the Void defects. Moreover, when the carbon concentration becomes $3 \times 10^{20}$ atoms/cm$^3$ or more, in addition to the degradation of the film quality of the silicon epitaxial film 3, productivity of the film is also decreased. The upper limit of the carbon concentration depends on the silicon epitaxial film thickness, and the upper limit of the carbon concentration can be determined from the following relational expression,

$6.6 \times 10^{20} \times \exp\{-1.6 \times$ [the thickness of the epitaxial film ($\mu$m)]$\} >$ [the carbon concentration of the epitaxial film (atoms/cm$^3$)],

in such a concentration, excellent high-frequency characteristics are stably achieved. This also applies to the method for manufacturing an SOI wafer described later.

The upper limit and the lower limit of the thickness of the silicon epitaxial film 3 can be, for example, 0.1 $\mu$m or more and 2.5 $\mu$m or less, considering productivity and cost. When the thickness of the silicon epitaxial film 3 is within this range, the silicon epitaxial film 3 has sufficiently high-frequency characteristics at a lower cost. However, when the silicon epitaxial film has a carbon concentration of $2.0 \times 10^{19}$ atoms/cm$^3$ or more, heat treatment of the silicon epitaxial film tends to form the Void defect region at the interface between the silicon epitaxial film and the silicon substrate. The Void defects are aggregates of vacancies, and therefore, the reduction of the amount of vacancy generated within the film by reducing the thickness of the silicon epitaxial film 3, leading to the suppression of the formation of the Void defects. Consequently, the film thickness is required to be adjusted according to the carbon concentration. Based on the above, a relation between the thickness and the carbon concentration of the silicon epitaxial film 3 is required to satisfy the following expression $6.6 \times 10^{20} \times \exp\{-1.6 \times$ [the thickness of the epitaxial film ($\mu$m)]$\} >$ [the carbon concentration of the epitaxial film (atoms/cm$^3$)].

(Experimental Example 1)

With regard to a carbon-doped silicon epitaxial film formed on a silicon substrate, the result of experimentally evaluated relation between carbon concentration and a film thickness of the epitaxial film will be described hereinafter, in which Void defects are not formed in the epitaxial film.

The present inventors formed silicon epitaxial films on a silicon substrate using a reduced-pressure CVD apparatus in which the films contained carbon of $2.0 \times 10^{19}$ atoms/cm$^3$ or more and had varied thicknesses (a sample having a carbon concentration of $2.0 \times 10^{19}$ atoms/cm$^3$ had a thickness of 1 $\mu$m, 1.5 $\mu$m, 2 $\mu$m, 3$\mu$m, and 5.5$\mu$m; a sample having a carbon concentration of $1.0 \times 10^{20}$ atoms/cm$^3$ had a thickness of 1 $\mu$m, 2 $\mu$m, and 3 $\mu$m; a sample having a carbon concentration of $3.0 \times 10^{20}$ atoms/cm$^3$ and that of $1.0 \times 10^{21}$ atoms/cm$^3$ had a thickness of 1 $\mu$m). An adjustment of the respective carbon concentration and thickness of the silicon epitaxial film was performed by varying the introduced amount of source gas and treatment time in a reduced-pressure CVD gas reactor.

In order to evaluate the presence or absence of the Void defect region in these epitaxial wafers, the obtained epitaxial wafers were subjected to heat treatment at 1000°C for 36 hours under an oxygen atmosphere. After heat treatment, a plan-view TEM observation was performed using thin samples (thickness of approximately 500 nm) that included an interface between the silicon epitaxial film and the silicon substrate of each epitaxial wafer.

As a result of Experimental Example 1, it was found that, in the sample having a carbon concentration of $2.0 \times 10^{19}$ atoms/cm$^3$ and a thickness of 3 $\mu$m or more, in the sample having a carbon concentration of $1.0 \times 10^{20}$ atoms/cm$^3$ and a thickness of 2 $\mu$m or more, and in the sample having a carbon concentration of $3.0 \times 10^{20}$ atoms/cm$^3$ or more and a thickness of 1 $\mu$m, the Void defect region was formed in the vicinity of the interface between the silicon epitaxial film and the silicon substrate.

According to the above result, the present inventors concluded that conditions under which the Void defects were formed in the silicon epitaxial film by heat treatment varied depending on both the carbon concentration contained in the silicon epitaxial film and the thickness of the silicon epitaxial film.

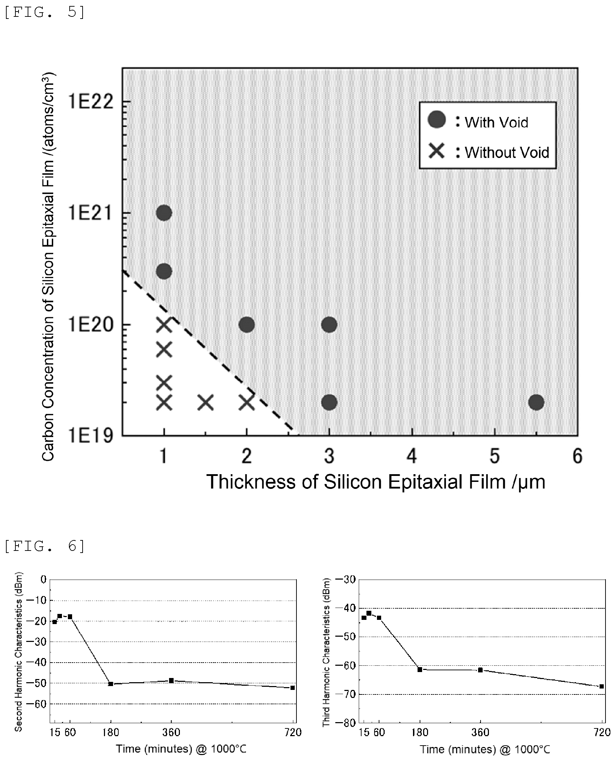

FIG. 5 shows a result in which the presence or the absence of the Void defect region shown in Experimental Example 1 was arranged by the carbon concentration contained in the silicon epitaxial film and the thickness of the silicon epitaxial film.

FIG. 5 is a graph showing the conditions of the carbon concentrations of the silicon epitaxial film and the thickness of the silicon epitaxial film, where Void defect regions are formed in the vicinity of the interface between the silicon epitaxial film and the silicon substrate, in the epitaxial wafer of the present invention. At this time, a region where the Void defect region is formed at the interface between the silicon epitaxial film and the silicon substrate after heat treatment is indicated by a dashed line and a shaded area in the figure. That is, a white area in the figure is a region where the Void defect region is not formed in the silicon epitaxial film. This can be a range, in the relation between the carbon concentration and the film thickness of the silicon epitaxial film, that satisfies the following expression,

$6.6 \times 10^{20} \times \exp\{-1.6 \times$ [the thickness of the epitaxial film ($\mu$m)]} > [the carbon concentration of the epitaxial film (atoms/cm$^3$)].

According to the inventive SOI wafer, a high-resistivity substrate is not required, and by using the silicon epitaxial film in which the minute carbon defects at high density are contained as the trap-rich layer, this SOI wafer exhibits superior harmonic reduction capability compared with a conventional SOI wafer employing a polysilicon layer as a trap-rich layer. Accordingly, such a wafer is suitable for a wafer for a high-frequency device.

Next, a method for manufacturing an SOI wafer according to the present invention will be described.

[First Embodiment]

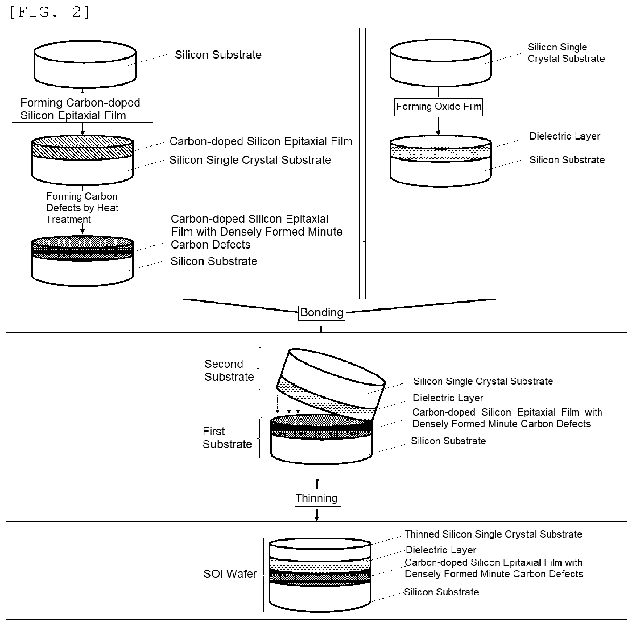

FIG. 2 shows an example of a method for manufacturing an SOI wafer according to the first embodiment of the present invention. This method is the method for manufacturing an SOI wafer, which employs a silicon epitaxial film in which minute carbon defects are formed at high density as a trap-rich layer.

First, a method for manufacturing an epitaxial wafer of a first substrate, which serves as a base wafer, will be described.

(Step of Providing First Substrate)

A silicon substrate having a resistivity of 10 to 5000 $\Omega\cdot$cm is provided as a first substrate.

(Step of Vapor-Phase Growing Silicon Epitaxial Film)

Next, a silicon epitaxial film having a carbon concentration of $2\times10^{19}$ atoms/cm$^3$ or more and less than $3\times10^{20}$ atoms/cm$^3$ is vapor-phase grown on the first substrate under reduced pressure.

Specifically, by supplying a gas containing silicon atoms and carbon atoms on the silicon substrate under reduced pressure, the silicon epitaxial film (hereinafter, also simply referred to as "epitaxial film") is vapor-phase grown on a surface of the first substrate, in which the silicon epitaxial film has a carbon concentration of $2\times10^{19}$ atoms/cm$^3$ or more and less than $3\times10^{20}$ atoms/cm$^3$ and a relation between the thickness and the carbon concentration of the silicon epitaxial film satisfies the following expression, $6.6\times10^{20} \times \exp\{-1.6 \times$ [the thickness of the epitaxial film ($\mu$m)]} > [the carbon concentration of the epitaxial film (atoms/cm$^3$)].

By vapor-phase growing the epitaxial film under reduced pressure, it is possible to lower the concentration of impurities other than carbon doped into the epitaxial film. A pressure for forming the epitaxial film may only be reduced pressure, and is not required to be limited, but it is preferable to form at approximately 10 Torr (about 1.3 kPa), for example, 5 Torr (about 0.67 kPa) or more, and 20 Torr (about 2.7 kPa) or less.

In the vapor-phase growth of the epitaxial film, the carbon doping is performed using the gas (raw material gas) containing the silicon atoms and the carbon atoms, as described above. As the raw material gas, it is preferable to contain at least one of monomethylsilane gas and trimethylsilane gas. By using those gases, it is possible to easily and favorably perform carbon-doping of the silicon epitaxial film. Moreover, as a carrier gas when supplying the raw material gas, an atmosphere for vapor-phase growth may contain hydrogen, argon, or the like.

With regard to the epitaxial film under reduced pressure, the epitaxial film can be more favorably formed, for example, by vapor-phase growth at 600 to 1000°C.

Moreover, the pressure, temperature, time, raw material gas concentration, and the like for the vapor-phase growth are preferably set appropriately such that the epitaxial film thickness to be formed has an intended thickness. The thickness of the epitaxial film can be, for example, 0.1 $\mu$m or more and 2.5 $\mu$m or less, but not limited thereto, as long as the thickness range satisfies the following expression,

$6.6 \times 10^{20} \times \exp\{-1.6 \times$ [the thickness of the epitaxial film ($\mu$m)]} > [the carbon concentration of the epitaxial film (atoms/cm$^3$)].

When the carbon concentration and the film thickness of the epitaxial film have such a relation, the Void defects are not formed in the epitaxial film.

(Step of Forming Carbon Defects)

Subsequently, by subjecting the epitaxial wafer having the epitaxial film to heat treatment, the minute carbon defects can be formed at high density in the epitaxial film.

A method of heat treatment after the formation of the epitaxial film is not particularly limited, and, for example, a typical heat treatment furnace for a silicon wafer or a chamber used for vapor-phase growth of the epitaxial film can be employed.

The lower limit of the heat treatment temperature during heat treatment is set to 900°C or more, and the upper limit is set to 1100°C or less. Accordingly, the minute carbon defects can be formed at high density using a typical heat treatment furnace while suppressing the influence of heavy metal diffusion, thereby improving manufacturing efficiency.

In addition, the heat treatment time is set to 3 hours or more and 36 hours or less. Accordingly, the epitaxial wafer has sufficient minute carbon defects formed therein, improved quality, and is excellent in terms of manufacturing efficiency.

Here, the results of studies regarding the heat treatment time in the heat treatment will be described in the following Experimental Example 2.

(Experimental Example 2)

The heat treatment time when forming minute carbon defects at high density is determined by the following experiments.

In order to perform a basic research on heat treatment time required for manufacturing an epitaxial wafer exhibiting excellent harmonic characteristics, an epitaxial wafer having a carbon concentration during the film-formation, set at $1.0 \times 10^{20}$ atoms/cm$^3$, was subjected to heat treatment at 1000°C with a heat treatment time varied in a range from 15 minutes to 12 hours under an oxygen atmosphere. Thereafter, in order to investigate high-frequency characteristics of this epitaxial wafer, second-harmonic characteristics and third-harmonic characteristics were measured.

The measurement of the high-frequency characteristics of an SOI wafer is performed as follows.

Measurement of the harmonic characteristics [second harmonic characteristics (2HD) and third harmonic characteristics (3HD)] includes: firstly, removing a silicon single crystal film, being the uppermost layer; then forming Co-planar Waveguide (CPW) made of metal (e.g., aluminum) on a dielectric layer (e.g., oxide film); grounding probes to both ends of metal electrodes; thereafter, inputting a high-frequency signal from one end of the electrodes; and measuring the second harmonics and the third harmonics output from the other end (e.g., input signal frequency: 1 GHz, input power: 15 dBm).

With regard to the epitaxial wafer in this experiment, aluminum electrodes having a line length of 2200 $\mu$m were formed on the silicon epitaxial film that had been subjected to heat treatment within the above-described range of heat treatment time, and the second harmonic characteristics and the third harmonic characteristics were measured. FIG. 6 shows measurement results. As shown in FIG. 6, when the input signal frequency was set to 1 GHz for the samples in which the heat treatment time was 3 hours or more, the second harmonic characteristics were all approximately -50 dBm, and the third harmonic characteristics were all -60 dBm or less.

These results indicate that, in order to manufacture an epitaxial wafer exhibiting excellent harmonic characteristics by forming the minute carbon defects at high density, it is required to perform heat treatment at 1000°C for at least 3 hours or more. Accordingly, the heat treatment time is set to 3 hours or more and 36 hours or less. Note that regarding the upper limit of the time, an effect for forming the carbon defects did not change even when treating for excessively long time; accordingly, the time was set to 36 hours or less, in consideration of productivity. In this way, the epitaxial wafer having sufficiently minute carbon defects formed therein, improved quality, and being excellent in view of productivity is obtained.

Based on the above, by directly placing the epitaxial wafer into a heat treatment furnace in which the temperature in the furnace was raised to approximately 1000°C, and subjecting the wafer to heat treatment for about 3 to 36 hours, the minute carbon defects are formed at high density in the epitaxial film that has been formed by vapor-phase growth under reduced pressure. In this case, a gas type during heat treatment is not particularly limited, and may be, for example, oxygen gas or an inert gas such as argon or nitrogen.

After the above heat treatment, the formation of the dielectric layer on the epitaxial film is not essential, and the dielectric layer may not be formed on the epitaxial film.

In this way, it is possible to manufacture an epitaxial wafer (base wafer) usable for a trap-rich layer in the SOI wafer according to the first embodiment of the present invention. The epitaxial film, in which the minute carbon defects are formed at high density, functions as the trap-rich layer.

Next, a method for producing a second substrate in the method for manufacturing an SOI wafer according to the first embodiment of the present invention will be described.

(Step of Providing Second Substrate)

A silicon single crystal substrate is provided as the second substrate. A resistivity of the second substrate can be, for example, a resistivity of about 10 $\Omega$·cm in the silicon single crystal substrate, but is not limited thereto. The resistivity can be determined as appropriate within a range of 10 to 1000 $\Omega$·cm, depending on a device to be produced.

(Step of Forming Dielectric Layer)

Next, the dielectric layer is formed on a surface of the second substrate. Material of the dielectric layer is not particularly limited, and can be formed from, for example, a silicon oxide film by thermal oxidation or pyrogenic oxidation. When an oxide film is formed as the dielectric layer, the oxide film can be formed across the substrate surface by thermal oxidation (oxidizing atmosphere, at 1000°C, for 1 to 12 hours). This second substrate serves as a bond wafer.

In FIG. 2, the order in which the first substrate and the second substrate are produced is not restricted. Either substrate may be produced first, and both may also be produced in parallel.

(Step of Bonding Epitaxial Film formed on First Substrate to Dielectric Layer of Second Substrate)

After providing the first substrate, which is the epitaxial wafer manufactured by vapor-phase growth and by subsequent heat treatment, and also providing the second substrate as described above, the epitaxial film of the first substrate and the dielectric layer of the second substrate are bonded (joined) as shown in FIG. 2.

After bonding, the silicon substrate of the second substrate can be thinned. This thinning includes methods such as polishing or etching the silicon substrate of the second substrate, or ion-implantation separation method, such that the silicon substrate can be thinned to a desired thickness according to the intended application. The ion-implantation separation method may be performed, for example, by implanting hydrogen ions or the like from the dielectric-layer side of the silicon substrate prior to bonding in FIG. 2 to form an ion-implanted layer within the silicon substrate, and then by performing separation along the ion-implanted layer after bonding by heat treatment or the like.

By the method for manufacturing an SOI wafer according to the first embodiment of the present invention, the SOI wafer can be manufactured. The SOI wafer thus manufactured has a structure in which, on a silicon substrate having a resistivity of 10 to 5000 $\Omega$·cm, an epitaxial film in which minute carbon defects are formed by heat treatment of an epitaxial film containing carbon at a concentration of $2 \times 10^{19}$ atoms/cm$^3$ or more and less than $3 \times 10^{20}$ atoms/cm$^3$, the dielectric layer, and the silicon single crystal film are stacked in this order.

When the epitaxial film has a carbon concentration of $2 \times 10^{19}$ atoms/cm$^3$ or more, a sufficient amount of minute carbon defects are formed by heat treatment, and this enables a significant reduction of the second harmonics and the third harmonics as compared with prior to the heat treatment. On the other hand, when the carbon concentration contained in the epitaxial film is $3 \times 10^{20}$ atoms/cm$^3$ or more, the quality of the epitaxial film is degraded and productivity is decreased.

It is preferable that minute carbon defects contained in the epitaxial film have a size of approximately 10 nm or less, and a density of approximately $1 \times 10^{10}$ cm$^{-2}$ or more in the epitaxial film (when the carbon concentration of the epitaxial film is lower than that in the present invention, the carbon defects having a size of approximately 25 nm or more are included at low density).

According to the method for manufacturing an SOI wafer of the first embodiment of the present invention, the SOI wafer in which minute carbon defects are formed at high density in the epitaxial film can be easily manufactured without using a high resistivity substrate. The manufactured SOI wafer has a superior harmonics reduction capability as compared with a conventional SOI wafer employing a polysilicon layer as a trap-rich layer, because the epitaxial film functions as the trap-rich layer, thereby reliably reducing harmonics. As a result, the SOI wafer is suitable as a wafer for a high-frequency device.

[Second Embodiment]

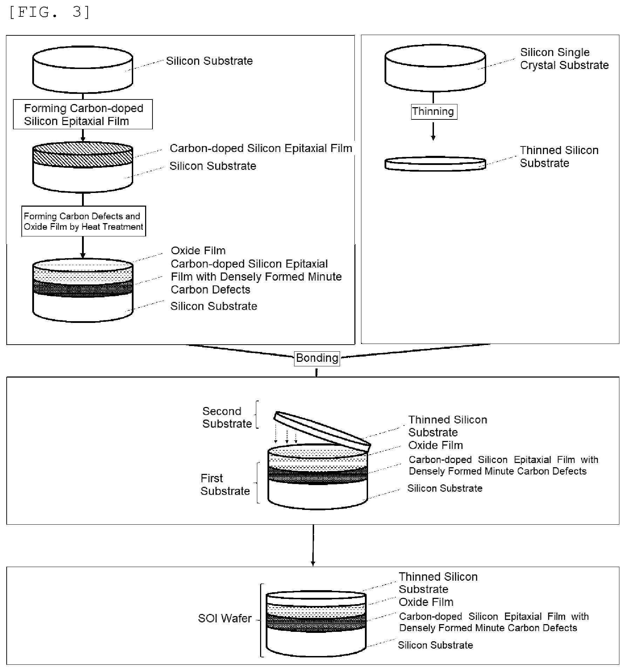

FIG. 3 shows an example of a method for manufacturing an SOI wafer according to the second embodiment of the present invention. This method is a method for manufacturing an SOI wafer which employs, as a trap-rich layer like above, a silicon epitaxial film in which minute carbon defects are formed at high density therein.

(Step of Providing First Substrate) to (Step of Vapor-Phase Growing Silicon Epitaxial Film)

First, a method for manufacturing an epitaxial wafer of the first substrate serving as a base wafer will be described. The step of providing a first substrate to the step of vapor-phase growing a silicon epitaxial film are the same as those in a method for manufacturing an epitaxial wafer according to the first embodiment shown in FIG. 2.

(Step of Forming Carbon Defects and Oxide Film)

In the method for manufacturing an SOI wafer according to the second embodiment, as shown in FIG. 3, the first substrate having the silicon epitaxial film formed thereon is subjected to heat treatment in an oxidizing atmosphere at a heat treatment temperature of 900°C or more and 1100°C or less for a heat treatment time of 3 hours or more and 36 hours or less, thereby forming the carbon defects in the silicon epitaxial film and forming an oxide film on the silicon epitaxial film as well. The heat treatment conditions in this case are as those described in the first embodiment, and by performing the heat treatment to form the carbon defects in an oxidizing atmosphere, both the formation of the carbon defects in the silicon epitaxial film and the formation of the oxide film on the epitaxial film are performed simultaneously.

The thickness of the oxide film is not particularly limited and can be adjusted depending on applications. However, in consideration of productivity, the thickness can be set to 100 nm or more and 1 $\mu$m or less.

According to the above-described method for manufacturing an SOI wafer of the second embodiment, it is also possible to manufacture an epitaxial wafer (base wafer) that functions as the trap-rich layer of the SOI wafer.

In the second embodiment, the oxide film is formed on the surface of the epitaxial film on the first substrate. The heat treatment required for forming the oxide film and forming the minute carbon defects at high density in the epitaxial film can be performed simultaneously in a same chamber, thereby enabling the reduction of the number of steps required for manufacturing the SOI wafer.

(Step of Providing Second Substrate)

As in the first embodiment described above, a second substrate, which is a silicon single crystal substrate, is provided. The second substrate, serving as a bond wafer, shown in FIG. 3, can be, for example, a silicon substrate having a resistivity of approximately 10 $\Omega$·cm, but is not limited thereto. The resistivity can be determined as appropriate within a range of 10 to 1000 $\Omega$·cm, depending on the device to be produced.

(Step of Bonding Oxide Film, which is formed on Epitaxial Film formed on First Substrate, to Second Substrate)

In the second embodiment, the oxide film has been formed on the epitaxial film; consequently, the step of forming the dielectric layer on the surface of the second substrate is not performed as in the first embodiment. However, this does not intend to exclude the presence of the dielectric layer. As shown in FIG. 3, the oxide film, which is formed on the epitaxial film formed on the first substrate, and the second substrate are bonded (joined).

In this case, it is preferable that the second substrate is a substrate obtained by cutting one silicon single crystal substrate into a plurality of substrates to thin the substrate prior to being bonded to the first substrate serving as the base wafer. The thinning method is not particularly limited, and thinning by polishing, an ion-implantation technique such as Smart Cut (registered trademark) method, or a laser cutting technique can be employed. However, from the viewpoint of the manufacturing cost, it is more advantageous to produce a plurality of the second substrates thinned from one silicon substrate prior to bonding to the first substrate, rather than thinning the substrates to an equivalent thickness after bonding.

The thickness of the thinned second substrate is also not particularly limited, and can be adjusted depending on the application and the thinning method. In this way, when a thinned silicon substrate having a thickness of approximately 60 $\mu$m is cut out from a silicon substrate (thickness of 775 $\mu$m) by a laser cutting technique prior to bonding, at least 10 or more second substrates required for manufacturing an SOI wafer can be produced. This is highly advantageous from the viewpoint of the manufacturing cost, and is therefore preferable. In this case, the second substrate serves as the bond wafer.

After bonding, the second substrate can be further thinned. In this case, the thinning to the desired thickness can be performed according to the application by methods such as polishing or etching, or an ion implantation separation method. The ion implantation separation method can be performed, for example, by implanting hydrogen ions or the like into the thinned silicon substrate from a side facing the oxide film (dielectric layer) of the first substrate prior to bonding, thereby forming an ion-implanted layer in the silicon substrate, and then separating thereof along the ion-implanted layer by heat treatment, or the like, after bonding.

In the manufacturing steps of the SOI wafer according to the second embodiment, the order in which the first substrate and the second substrate are produced in FIG. 3 is not restricted. Either substrate may be produced first, and both may also be produced in parallel. Moreover, the order of thinning the second substrate and bonding thereof is not restricted. The second substrate may be thinned before bonding, or bonding may be performed first and thinning thereafter. Either approach may be employed.

By the method for manufacturing an SOI wafer according to the second embodiment of the present invention, the SOI wafer can be manufactured. The SOI wafer thus manufactured has a structure in which, on a silicon substrate having a resistivity of 10 to 5000 $\Omega$·cm, an epitaxial film in which minute carbon defects are formed by heat treatment of an epitaxial film containing carbon at a concentration of $2\times10^{19}$ atoms/cm$^3$ or more and less than $3\times10^{20}$ atoms/cm$^3$, the dielectric

layer, and the silicon single crystal film are stacked in this order.

It is preferable that minute carbon defects contained in the epitaxial film have a size of approximately 10 nm or less, and a density of approximately $1 \times 10^{10}$ cm$^{-2}$ or more in the epitaxial film (when the carbon concentration of the epitaxial film is lower than that in the present invention, the carbon defects having a size of approximately 25 nm or more are included at low density).

According to the method for manufacturing an SOI wafer of the second embodiment of the present invention, the SOI wafer in which minute carbon defects are formed at high density in the epitaxial film can be easily manufactured without using a high resistivity substrate. The manufactured SOI wafer has a superior harmonics reduction capability as compared with a conventional SOI wafer employing a polysilicon layer as a trap-rich layer, because the epitaxial film functions as a trap-rich layer, thereby reliably reducing harmonics. As a result, the SOI wafer is suitable as a wafer for a high-frequency device.

[Third Embodiment]

An SOI wafer according to the present invention can also be manufactured by a method described below.

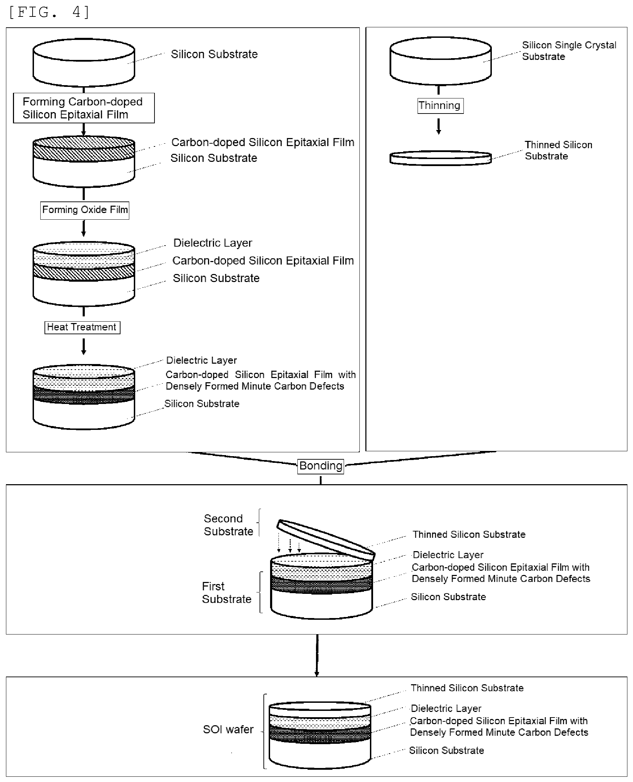

First, a method for manufacturing an epitaxial wafer of a first substrate serving as a base wafer will be described. A production method of a carbon-doped silicon epitaxial film (hereinafter, also simply referred to as "epitaxial film") on the first substrate shown in FIG. 4 is the same as a method for manufacturing an epitaxial wafer according to the first embodiment shown in FIG. 2.

In a method for manufacturing an SOI wafer according to the third embodiment, as shown in FIG. 4, a dielectric layer is formed on the first substrate, on which the epitaxial film has been formed. In this case, an oxide film is formed as the dielectric layer.

As a method for forming the oxide film (dielectric layer), oxidation of the entire substrate surface by thermal oxidation or pyrogenic oxidation may be employed (oxidizing atmosphere, at 1000°C, for 1 to 12 hours). This treatment is not particularly limited as long as it is performed under the oxidizing atmosphere. The thickness of the oxide film (dielectric layer) is also not particularly limited, and can be adjusted depending on the application; however, in consideration of productivity, the thickness can be set to 100 nm or more and 1 $\mu$m or less.

By subjecting the first substrate, on which the oxide film (dielectric layer) has been formed, to heat treatment at a heat treatment temperature of 900°C or more and 1100°C or less, for a heat treatment time of 3 hours or more and 36 hours or less, carbon defects are formed in the silicon epitaxial film. Heat treatment conditions in this case are the same as described in the above first embodiment.

However, when a sufficient amount of minute carbon defects has been formed in the silicon epitaxial film by the oxidation treatment for forming the oxide film (dielectric layer), the substrate without the heat treatment may be used as the first substrate (base wafer) as it is. When the formation of the carbon defects is insufficient, the minute carbon defects can be formed in the epitaxial film by additional heat treatment in an oxidizing atmosphere. Alternatively, when the thickness of the oxide film (dielectric layer) is not required to be further thickened, an inert gas can be used as an atmosphere for an additional heat treatment. The implementation of the additional heat treatment and the conditions thereof can be adjusted depending on the circumstances and are not particularly limited.

According to the method for manufacturing an SOI wafer of the third embodiment described above, the epitaxial wafer (base wafer) that functions as a trap-rich layer of the SOI wafer can also be manufactured.

In the third embodiment, the oxide film (dielectric layer) is formed on the epitaxial film surface, which is on the first substrate. As a result, the heat treatment required for forming the oxide film (dielectric layer) and forming the minute carbon defects at high density in the epitaxial film can be performed stepwise in a same chamber, thereby enabling the reduction of the number of steps required for manufacturing the SOI wafer.

Next, a method for producing a second substrate in a method for manufacturing an SOI wafer according to the third embodiment will be described.

The second substrate serving as a bond wafer shown in FIG. 4 can be, for example, a silicon substrate having a resistivity of approximately 10 $\Omega$·cm, but is not limited thereto. Depending on the devices to be produced, the resistivity can be appropriately determined within a range of 10 to 1000 $\Omega$·cm.

In the third embodiment, no dielectric layer is formed on the second substrate; however, this does not intend to exclude the presence of the dielectric layer.

As described above, after providing the first substrate, which is the epitaxial wafer produced by vapor-phase growth and formation of the oxide film (dielectric layer), and subsequent heat treatment, and providing the second substrate, the oxide film (dielectric layer) formed on the first substrate is bonded (joined) to the second substrate as shown in FIG. 4. In this way, the SOI wafer can be manufactured.

At this time, the second substrate can be thinned either before or after bonding using the same methods as in thinning in the second embodiment.

In the manufacturing steps of the SOI wafer according to the third embodiment, the order in which the first substrate and the second substrate are produced in FIG. 4 is not restricted. Either substrate may be produced first, and both may also be produced in parallel. Moreover, the order of thinning the second substrate and bonding thereof is not restricted. The second substrate may be thinned before bonding, or bonding may be performed first and thinning thereafter. Either approach may be employed.

By the method for manufacturing an SOI wafer according to the third embodiment of the present invention, the SOI wafer according to the present invention can be manufactured. The SOI wafer thus manufactured has a structure in which, on a silicon substrate having a resistivity of 10 to 5000 $\Omega \cdot$cm, an epitaxial film in which minute carbon defects are formed at high density by heat treatment of an epitaxial film containing carbon at a concentration of $2 \times 10^{19}$ atoms/cm$^3$ or more and less than $3 \times 10^{20}$ atoms/cm$^3$, the oxide film (dielectric layer), and the silicon single crystal film are stacked in this order.

It is preferable that the minute carbon defects contained in the epitaxial film have a size of approximately 10 nm or less, and a density of approximately $1 \times 10^{10}$ cm$^{-2}$ or more in the epitaxial film (when the carbon concentration of the epitaxial film is lower than that in the present invention, the carbon defects having a size of approximately 25 nm or more are included at low density).

According to the method for manufacturing an SOI wafer of the third embodiment of the present invention, the SOI wafer in which minute carbon defects are formed at high density in the epitaxial film can be easily manufactured without using a high resistivity substrate. The manufactured SOI wafer has a superior harmonics reduction capability as compared with a conventional SOI wafer employing a polysilicon layer as a trap-rich layer, because the epitaxial film functions as a trap-rich layer, thereby reliably reducing harmonics. As a result, the SOI wafer is suitable as a wafer for a high-frequency device.

[High-Frequency Characteristics]

High-frequency characteristics of the SOI wafer will be described.

The inventive SOI wafer has minute carbon defects at high density formed in the carbon-doped silicon epitaxial film on the silicon substrate by heat treatment. Accordingly, the trap density of the trap-rich layer is increased compared with that before the heat treatment, resulting in improved carrier trapping capability. Consequently, even when the silicon substrate is not of high resistivity, harmonics can be significantly reduced as compared with those of a conventional SOI wafer in which a polysilicon layer is formed as a trap-rich layer on a high resistivity substrate, and excellent harmonic characteristics can be obtained.

In this way, the inventive SOI wafer can improve the second harmonic characteristics and the third harmonic characteristics, and thus, is suitable for the wafer for a high-frequency device.

EXAMPLES

Hereinafter, the present invention will be specifically described with reference to Examples. However, the present invention is not limited thereto.

(Example 1)

In accordance with FIG. 2, an epitaxial wafer serving as a first substrate (base wafer), which functioned as a trap-rich layer in a method for manufacturing an SOI wafer according to the first embodiment of the present invention, was manufactured.

Specifically, a carbon-doped silicon epitaxial film (carbon concentration: $2.0 \times 10^{19}$ to $1.0 \times 10^{20}$ atoms/cm$^3$, film thickness: 1 $\mu$m) was formed on a silicon substrate having a diameter of 300 mm (P-type, resistivity of 10 $\Omega \cdot$cm) using monomethylsilane as carbon source gas, in which the silicon substrate was obtained by slicing a single crystal ingot produced by a Czochralski method employing a reduced pressure CVD apparatus. When the carbon concentration is within this range, Void defects are not formed when the film thickness is 0.1 to 1.1 $\mu$m. After forming the film, the resulting epitaxial wafer was subjected to heat treatment at 1000°C for 12 hours in a non-oxidizing atmosphere, thereby forming minute carbon defects at high density in the silicon epitaxial film. At this time, the oxide film was not formed on the silicon epitaxial film.

The carbon concentrations in the carbon-doped silicon epitaxial film were set to the following four values:

(1) $2.0 \times 10^{19}$ atoms/cm$^3$,
(2) $3.0 \times 10^{19}$ atoms/cm$^3$,
(3) $6.0 \times 10^{19}$ atoms/cm$^3$,
(4) $1.0 \times 10^{20}$ atoms/cm$^3$.

Subsequently, an SOI wafer was manufactured using the heat-treated epitaxial wafer. As a second substrate, to be a bond wafer, a silicon wafer was provided on which an oxide film having a thickness of 400 nm was formed as a dielectric layer on a surface of a silicon substrate having a diameter of 300 mm (P-type, resistivity of 10 $\Omega\cdot$cm).

The silicon epitaxial film surface formed on the first substrate, in which the minute carbon defects were formed, was bonded to the oxide film surface (dielectric layer surface) of the second substrate. Thereafter, by polishing the silicon substrate of the second substrate, the SOI wafer was manufactured, where the silicon single crystal film of 1 $\mu$m was left. This wafer was defined as the SOI wafer in Example 1.

In order to investigate high-frequency characteristics of the SOI wafer in Example 1, second harmonic characteristics and third harmonic characteristics of the SOI wafer in Example 1 were measured. After removing the silicon single crystal film on the second substrate side of the manufactured SOI wafer, aluminum electrodes having a line length of 2200 $\mu$m were formed on the dielectric layer exposed on the surface of the silicon epitaxial film [carbon concentration: (1) to (4), film thickness: 1 $\mu$m], in which the minute carbon defects were formed at high density, and the high-frequency characteristics were measured.

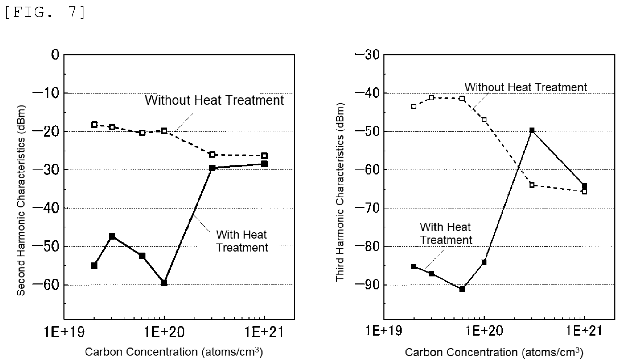

FIG. 7 shows the above measurement results. As shown in FIG. 7, when frequency of input signal was set to 1 GHz, the second harmonic characteristics of the wafers, for the cases in which the carbon concentrations of the silicon epitaxial films were (1) to (4), were (1) -55.0 dBm, (2) -47.3 dBm, (3) -52.4 dBm, and (4) -59.5 dBm, respectively.

Moreover, the third harmonic characteristics, for the cases in which the carbon concentrations of the silicon epitaxial films were (1) to (4), were (1) -85.2 dBm, (2) -87.1 dBm, (3) -91.2 dBm, and (4) -84.1 dBm, respectively.

These results indicated that the epitaxial wafer in Example 1 was capable of significantly reducing the harmonics. Accordingly, when applied to the first substrate (base wafer) of the SOI wafer, it was found that this epitaxial wafer was excellent as the trap-rich layer.

(Comparative Example 1)

An SOI wafer was manufactured in the same way as that for manufacturing an SOI wafer in Example 1, except that heat treatment was not performed after forming a silicon epitaxial layer on a first substrate. This wafer was defined as the SOI wafer in Comparative Example 1.

In the same way as in Example 1, second harmonic characteristics and third harmonic characteristics of the SOI wafer in Comparative Example 1 were measured, and FIG. 7 shows the results thereof.

As shown in FIG. 7, the second harmonic characteristics of the wafer, for the cases in which the carbon concentrations of the silicon epitaxial films were (1) to (4), were (1) -18.3 dBm, (2) -18.8 dBm, (3) -20.4 dBm, and (4) -19.9 dBm, respectively.

Moreover, the third harmonic characteristics were (1) -43.4 dBm, (2) -41.2 dBm, (3) -41.4 dBm, and (4) - 47.0 dBm.

Based on the results, it was found that both the second harmonic characteristics and the third harmonic characteristics in Comparative Example 1 were inferior to those in Example 1.

From the above results, it was found that, when the epitaxial layer in which the minute carbon defects at high density were formed by subjecting the carbon-doped silicon epitaxial film in which the carbon concentration of the silicon epitaxial film was set to $2\times10^{19}$ atoms/cm$^3$ or more and less than $3\times10^{20}$ atoms/cm$^3$, and a relation between the thickness and the carbon concentration of the silicon epitaxial film satisfied $6.6 \times 10^{20} \times \exp\{-1.6 \times$ [the thickness of the epitaxial film ($\mu$m)]\} > [the carbon concentration of the epitaxial film (atoms/cm$^3$)] to heat treatment was applied to the first substrate (base wafer) of the SOI wafer, this layer was superior as the trap-rich layer compared with an epitaxial layer containing no carbon defect when this layer was applied to the first substrate (base wafer) of the SOI wafer.

(Comparative Example 2)

An epitaxial wafer was manufactured in the same way as methods for manufacturing an epitaxial wafer in Example 1 and Comparative Example 1, except that carbon concentration contained in the silicon epitaxial film was different.

First, a carbon-doped silicon epitaxial film (carbon concentration: $3.0 \times 10^{20}$ to $1.0\times10^{21}$ atoms/cm$^3$, film thickness: 1 $\mu$m) was formed on a silicon substrate having a diameter of 300 mm (P-type, resistivity of 10 $\Omega\cdot$cm) using monomethylsilane as carbon source gas, in which the silicon substrate was obtained by slicing a single crystal ingot produced by a Czochralski method employing a reduced pressure CVD apparatus. Accordingly, a first substrate (base wafer) of an SOI wafer in Comparative Example 2 was provided. When the carbon concentration is within this range, it has been found that Void defects are formed when the film thickness is 1 $\mu$m or more. Samples subjected to heat treatment at 1000°C for 12 hours in an oxygen atmosphere, and samples without heat treatment were provided to each of the above base wafers.

The carbon concentration of the carbon-doped silicon epitaxial film was set to two values: (1) $3.0 \times 10^{20}$

atoms/cm$^3$, (2) $1.0 \times 10^{21}$ atoms/cm$^3$.

Subsequently, as a second substrate (bond wafer), a silicon wafer was provided on which an oxide film having a thickness of 400 nm was formed as a dielectric layer on a surface of a silicon substrate having a diameter of 300 mm (P-type, resistivity of 10 $\Omega\cdot$cm). The silicon epitaxial film surface of the base wafer was bonded to the oxide film surface of the bond wafer (surface of dielectric layer). Thereafter, by polishing the silicon substrate of the bond wafer side, an SOI wafer was provided, where the silicon single crystal film of 1 $\mu$m was left. This wafer was defined as the SOI wafer in Comparative Example 2.

In the same way as in Example 1, second harmonic characteristics and third harmonic characteristics of the SOI wafer in Comparative Example 2 were measured, and results are shown in FIG. 7.

As shown in FIG. 7, when input signal frequency was set to 1 GHz, the second harmonic characteristics of the wafer (without heat treatment), for cases in which the carbon concentrations of the silicon epitaxial films were (1) and (2), were (1) -26.0 dBm and (2) -26.3 dBm, respectively, and the second harmonic characteristics (with heat treatment) were (1) -29.5 dBm and (2) -28.5 dBm.

Moreover, the third harmonic characteristics (without heat treatment) were (1) -64.0 dBm and (2) - 65.7 dBm, and the third harmonic characteristics (with heat treatment) were (1) -49.7 dBm and (2) -64.2 dBm.

These results indicate that both the second harmonic characteristics and the third harmonic characteristics in Comparative Example 2 were inferior to those in Example 1.

(Example 2)

In accordance with FIG. 3, an epitaxial wafer, serving as a first substrate (base wafer) functioning as a trap-rich layer, was manufactured using a method for manufacturing an SOI wafer according to the second embodiment of the present invention.

Specifically, a carbon-doped silicon epitaxial film (carbon concentration: $2.0\times10^{19}$ to $1.0\times10^{20}$ atoms/cm$^3$, film thickness: 1 $\mu$m) was formed on a silicon substrate having a diameter of 300 mm (P-type, resistivity of 10 $\Omega\cdot$cm) using monomethylsilane as carbon source gas, in which the silicon substrate was obtained by slicing an ingot produced by a Czochralski method employing a reduced pressure CVD apparatus. When the carbon concentration is within this range, Void defects are not formed when the film thickness is 0.1 to 1.1 $\mu$m. After forming the film, the resulting epitaxial wafer was subjected to heat treatment at 1000°C for 12 hours in an oxidizing atmosphere, thereby forming minute carbon defects at high density in the silicon epitaxial film. At this time, an oxide film was formed on the silicon epitaxial film.

A surface of the silicon epitaxial film formed on the first substrate, in which the oxide film was provided on the surface and the minute carbon defects were formed therein, was bonded to a silicon substrate of a second substrate having a diameter of 300 mm (P-type, resistivity of 10 $\Omega\cdot$cm). Thereafter, by polishing the silicon substrate of the second substrate, an SOI wafer was manufactured, where the silicon single crystal film of 1 $\mu$m was left. This wafer was defined as the SOI wafer in Example 2.

In the same way as in Example 1, second harmonic characteristics and third harmonic characteristics of the SOI wafer in Example 2 were measured. As a result, it was confirmed that the SOI wafer in Example 2 exhibited high-frequency characteristics almost equivalent to those of Example 1. From these findings, it was demonstrated that, regardless of whether the first embodiment or the second embodiment was employed, the SOI wafer exhibiting equivalent high-frequency characteristics can be manufactured.

(Example 3)

In accordance with FIG. 4, an epitaxial wafer, serving as a first substrate (base wafer) functioning as a trap-rich layer, was manufactured using a method for manufacturing an SOI wafer according to the third embodiment of the present invention. A carbon-doped silicon epitaxial film (carbon concentration: $2.0\times10^{19}$ to $1.0\times10^{20}$ atoms/cm$^3$, film thickness: 1 $\mu$m) was formed on a silicon substrate having a diameter of 300 mm (P-type, resistivity of 10 $\Omega\cdot$cm) using monomethyl-silane as carbon source gas, in hich the silicon substrate was obtained by slicing an ingot produced by a Czochralski method employing a reduced pressure CVD apparatus. When the carbon concentration is within this range, Void defects are not formed when the film thickness is 0.1 to 1.1 $\mu$m. After forming the film, the epitaxial wafer was subjected to pyrogenic oxidation (at 1000°C for 4 hours), thereby forming the oxide film of 400 nm, serving as a dielectric layer on the carbon-doped silicon epitaxial film surface. The resulting epitaxial wafer was subjected to heat treatment at 1000°C for 8 hours in a non-oxidizing atmosphere to form the minute carbon defects in the silicon epitaxial film. This wafer was employed as the base wafer in Example 3. In the third embodiment, it is required for the oxide film to be formed on this silicon epitaxial film.

Subsequently, an SOI wafer was manufactured using the base wafer. As a second substrate (bond wafer), a silicon substrate having a diameter of 300 mm (thickness of 775 $\mu$m, P-type, resistivity of 10 $\Omega\cdot$cm) was thinned by laser-cutting to produce the bond wafer having a thickness of approximately 100 $\mu$m. Next, on the first substrate, the dielectric layer on a surface of the silicon epitaxial film in which minute carbon defects had been formed was bonded to the bond wafer to manufacture the SOI wafer. This wafer was defined as the SOI wafer in Example 3.

In the same way as in Example 1, second harmonic characteristics and third harmonic characteristics of the SOI wafer in Example 3 were measured. As a result, it was confirmed that this SOI wafer exhibited high-frequency characteristics almost equivalent to those in Example 1. From these findings, it was demonstrated that, irrespective of whether the first embodiment, the second embodiment, or the third embodiment was employed, the SOI wafer exhibiting equivalent high-frequency characteristics can be manufactured.

Further, in Example 3, five pieces of second substrates required for producing the SOI wafers were successfully produced from one silicon substrate. This provides significant advantages in terms of manufacturing cost.

As described above, according to Examples of the present invention, the SOI wafer having superior high-frequency characteristics compared with a conventional SOI wafer employing a polysilicon layer as a trap-rich layer was successfully manufactured easily without using a high resistivity substrate, and by allowing the silicon epitaxial film, containing the minute carbon defects at high density, to function as a trap-rich layer.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

**Claims**

1. An SOI wafer comprising, in this order, a silicon epitaxial film having a carbon concentration of $2 \times 10^{19}$ atoms/cm$^3$ or more and less than $3 \times 10^{20}$ atoms/cm$^3$ and containing carbon defects, a dielectric layer, and a silicon single crystal film on a silicon single crystal substrate having a resistivity of 10 $\Omega \cdot$cm or more and 5000 $\Omega \cdot$cm or less, wherein a thickness of the silicon epitaxial film satisfies $6.6 \times 10^{20} \times \exp\{-1.6 \times$ [the thickness of the epitaxial film ($\mu$m)]$\}$ > [the carbon concentration of the epitaxial film (atoms/cm$^3$)].

2. The SOI wafer according to claim 1, wherein
   the SOI wafer is a wafer for a high-frequency device.

3. The SOI wafer according to claim 1 or 2, wherein
   the carbon defects have a size of 10 nm or less, and a density of $1 \times 10^{10}$ cm$^{-2}$ or more in the silicon epitaxial film.

4. A method for manufacturing an SOI wafer, the method comprising the steps of:

   providing a first substrate that is a silicon single crystal substrate having a resistivity of 10 $\Omega \cdot$cm or more and 5000 $\Omega \cdot$cm or less;
   vapor-phase growing a silicon epitaxial film having a carbon concentration of $2 \times 10^{19}$ atoms/cm$^3$ or more and less than $3 \times 10^{20}$ atoms/cm$^3$ on the first substrate, under reduced pressure;
   forming carbon defects in the silicon epitaxial film by subjecting the first substrate on which the silicon epitaxial film has been formed to heat treatment at a heat treatment temperature of 900°C or more and 1100°C or less for a heat treatment time of 3 hours or more and 36 hours or less;
   providing a second substrate that is a silicon single crystal substrate;
   forming a dielectric layer on a surface of the second substrate; and
   bonding the epitaxial film formed on the first substrate to the dielectric layer of the second substrate, wherein the silicon epitaxial film is formed in the step of vapor-phase growing a silicon epitaxial film, in which the silicon epitaxial film has a thickness that satisfies $6.6 \times 10^{20} \times \exp\{-1.6 \times$ [the thickness of the epitaxial film ($\mu$m)]$\}$ > [the carbon concentration of the epitaxial film (atoms/cm$^3$)].

5. A method for manufacturing an SOI wafer, the method comprising the steps of:

   providing a first substrate that is a silicon single crystal substrate having a resistivity of 10 $\Omega \cdot$cm or more and 5000 $\Omega \cdot$cm or less;
   vapor-phase growing a silicon epitaxial film having a carbon concentration of $2 \times 10^{19}$ atoms/cm$^3$ or more and less than $3 \times 10^{20}$ atoms/cm$^3$ on the first substrate, under reduced pressure;

forming carbon defects in the silicon epitaxial film and forming an oxide film on the silicon epitaxial film, by subjecting the first substrate on which the silicon epitaxial film has been formed to heat treatment at a heat treatment temperature of 900°C or more and 1100°C or less for a heat treatment time of 3 hours or more and 36 hours or less in an oxidizing atmosphere;

providing a second substrate that is a silicon single crystal substrate; and

bonding the oxide film, which is formed on the epitaxial film formed on the first substrate, to the second substrate, wherein

the silicon epitaxial film is formed in the step of vapor-phase growing a silicon epitaxial film, in which the silicon epitaxial film has a thickness that satisfies $6.6 \times 10^{20} \times \exp\{-1.6 \times$ [the thickness of the epitaxial film ($\mu$m)]$\}$ > [the carbon concentration of the epitaxial film (atoms/cm$^3$)].

6. The method for manufacturing an SOI wafer according to claim 5, wherein
the second substrate is a substrate obtained by cutting one silicon single crystal substrate into a plurality of substrates to thin the substrate prior to being bonded to the first substrate.

7. The method for manufacturing an SOI wafer, wherein
the SOI wafer manufactured by the method for manufacturing an SOI wafer according to claim 4 or 5 is employed as a wafer for a high-frequency device.

8. The method for manufacturing an SOI wafer according to claim 4 or 5, wherein
the carbon defects have a size of 10 nm or less, and a density of $1 \times 10^{10}$ cm$^{-2}$ or more in the epitaxial film.

[FIG. 1]

1

[FIG. 2]

[FIG. 3]

[FIG. 4]

[FIG. 5]

[FIG. 6]

[FIG. 7]

# EP 4 770 401 A1

## INTERNATIONAL SEARCH REPORT

International application No.

**PCT/JP2024/028032**

### A. CLASSIFICATION OF SUBJECT MATTER

**H01L 27/12**(2006.01)i; **H01L 21/02**(2006.01)i; **H01L 21/20**(2006.01)i; **H01L 21/205**(2006.01)i; **H01L 21/324**(2006.01)i; *C30B 25/20*(2006.01)n; *C30B 29/06*(2006.01)n; *C30B 33/02*(2006.01)n

FI: H01L27/12 B; H01L21/20; H01L21/205; H01L21/324 X; C30B25/20; C30B29/06 A; C30B33/02

According to International Patent Classification (IPC) or to both national classification and IPC

### B. FIELDS SEARCHED

Minimum documentation searched (classification system followed by classification symbols)

H01L27/12; H01L21/02; H01L21/20; H01L21/205; H01L21/324; C30B25/20; C30B29/06; C30B33/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2023-54965 A (SHIN-ETSU HANDOTAI CO., LTD.) 17 April 2023 (2023-04-17) entire text, all drawings | 1-8 |
| A | WO 2023/054334 A1 (SHIN-ETSU HANDOTAI CO., LTD.) 06 April 2023 (2023-04-06) entire text, all drawings | 1-8 |
| A | JP 2009-200231 A (SUMCO CORP.) 03 September 2009 (2009-09-03) entire text, all drawings | 1-8 |
| P, A | JP 2024-61997 A (SHIN-ETSU HANDOTAI CO., LTD.) 09 May 2024 (2024-05-09) entire text, all drawings | 1-8 |
| E, A | JP 2024-134795 A (SHIN-ETSU HANDOTAI CO., LTD.) 04 October 2024 (2024-10-04) entire text, all drawings | 1-8 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **17 October 2024** | **29 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

### INTERNATIONAL SEARCH REPORT
**Information on patent family members**

International application No.

**PCT/JP2024/028032**

| Patent document cited in search report | | | Publication date (day/month/year) | Patent family member(s) | | | Publication date (day/month/year) |
|---|---|---|---|---|---|---|---|
| JP | 2023-54965 | A | 17 April 2023 | (Family: none) | | | |
| WO | 2023/054334 | A1 | 06 April 2023 | CN | 118043947 | A | |
| | | | | TW | 202338934 | A | |
| JP | 2009-200231 | A | 03 September 2009 | (Family: none) | | | |
| JP | 2024-61997 | A | 09 May 2024 | JP | 7416171 | B1 | |
| JP | 2024-134795 | A | 04 October 2024 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015503853 A
- JP 2019129195 A
- JP 2009164590 A
- JP 2009200231 A
- JP 2006216934 A